# EUROPÄISCHE PATENTSCHRIFT

(11) **EP 3 721 469 B1**
(45) Veröffentlichungstag und Bekanntmachung des Hinweises auf die Patenterteilung: **18.03.2026**
(21) Anmeldenummer: 18811247.8
(22) Anmeldetag: 28.11.2018
(51) Int. Cl.: H01L 21/205, H01L 21/687, C30B 25/10, C30B 25/12, C30B 29/06, C23C 16/458, C23C 16/46, C30B 25/20, H01L 21/67

(54) **VERFAHREN ZUM ABSCHEIDEN EINER EPITAKTISCHEN SCHICHT AUF EINER VORDERSEITE EINER HALBLEITERSCHEIBE UND VORRICHTUNG ZUR DURCHFÜHRUNG DES VERFAHRENS**
METHOD FOR DEPOSITING AN EPITAXIAL LAYER ON A FRONT SIDE OF A SEMICONDUCTOR WAFER AND DEVICE FOR CARRYING OUT THE METHOD
PROCÉDÉ DE SÉPARATION D'UNE COUCHE ÉPITAXIALE SUR UNE FACE AVANT D'UNE TRANCHE DE MATÉRIAU SEMI-CONDUCTEUR ET DISPOSITIF D'EXÉCUTION DU PROCÉDÉ

(30) Priorität: 08.12.2017 DE 102017222279
(43) Veröffentlichungstag der Anmeldung: 14.10.2020
(73) Patentinhaber: Siltronic AG, 81677 München (DE)
(72) Erfinder: HABERECHT, Jörg, 09599 Freiberg (DE); STEIN, Rene, 09627 Bobritzsch-Hilbersdorf (DE); HEINRICH, Stephan, 09599 Freiberg (DE)
(74) Vertreter: Staudacher, Wolfgang
(86) Internationale Anmeldenummer: PCT/EP2018/082820
(87) Internationale Veröffentlichungsnummer: WO 2019/110386

(56) Entgegenhaltungen:
- WO-A1-2013/155073
- WO-A2-2011/075563
- DE-B3- 102016 210 203
- DE-T5- 112013 005 951
- US-A1- 2007 227 441
- US-A1- 2015 275 395

## Beschreibung

Gegenstand der Erfindung ist ein Verfahren zum Abscheiden einer epitaktischen Schicht auf der Vorderseite einer Halbleiterscheibe aus einkristallinem Material, im Zuge dessen eine bereitgestellte Halbleiterscheibe auf einem Suszeptor angeordnet und mittels Wärmestrahlung auf eine Abscheidetemperatur erhitzt wird, und ein Abscheidegas über eine Vorderseite der Halbleiterscheibe geleitet wird. Gegenstand der Erfindung ist des Weiteren eine Vorrichtung zum Abscheiden einer epitaktischen Schicht auf einer Vorderseite einer Halbleiterscheibe aus einkristallinem Material.

### Stand der Technik / Probleme

Das Abscheiden einer epitaktischen Schicht auf der Vorderseite einer Halbleiterscheibe geschieht üblicherweise mittels CVD (chemical vapor deposition) in einem CVD-Reaktor, häufig in einem Einzelscheiben-Reaktor. Beispielsweise sei die US 2014/0 251 208 A1 erwähnt, in der ein solcher CVD-Reaktor beschrieben ist. Ein Einzelscheiben-Reaktor stellt zwischen einem oberen und einem unteren Deckel (dome) einen Reaktionsraum bereit, in dem ein Suszeptor von Suszeptor-Tragarmen einer Suszeptor-Tragwelle auf Suszeptor-Stützstiften gehalten wird. Der Suszeptor und eine darauf abgelegte Halbleiterscheibe wird durch Lampenreihen (arrays), die über und unter den Deckeln angeordnet sind, mittels Wärmestrahlung erhitzt, während ein Abscheidegas über die, zum oberen Deckel weisende Vorderseite der Halbleiterscheibe geleitet wird.

In WO 2011 075 563 A2 ist eine Vorrichtung zum Abscheiden von Halbleitermaterial beschrieben, die das Einstrahlen von Wärmestrahlung ausschließlich von oben vorsieht und zum Ausgleich dafür einen dreiteiligen Substrat-Träger vorsieht, der von der Rückseite des Substrats ausgesendete Wärmestrahlung reflektiert.

In US 2008/0118712 A1 ist ein Suszeptor beschrieben, umfassend einen Suszeptorring und einen Suszeptorboden. Der Suszeptorring hat einen Sims (ledge) zum Ablegen einer Halbleiterscheibe im Randbereich der Rückseite der Halbleiterscheibe. Zum Abscheiden einer Schicht auf der Vorderseite der Halbleiterscheibe wird der Suszeptorring auf dem Suszeptorboden abgelegt.

In US 2007/0227441 A1 wird auf periodische Schwankungen der Dicke im Randbereich von epitaktisch beschichteten Halbleiterscheiben aus Silizium hingewiesen. Grund sind unterschiedliche Wachstumsgeschwindigkeiten, mit denen die epitaktische Schicht wächst. Die unterschiedlichen Wachstumsgeschwindigkeiten stehen in einem Zusammenhang mit der Kristallorientierung der Vorderseite der Halbleiterscheibe. Die Vorderseite der Halbleiterscheibe ist diejenige Seitenfläche der Halbleiterscheibe, auf der die epitaktische Schicht abgeschieden wird. Um die Dicke der epitaktischen Schicht im Randbereich zu vergleichmäßigen, wird in US 2007/0227441 A1 vorgeschlagen, die Struktur des Suszeptors mit der Periode der Dickenschwankungen zu verändern.

Mit derselben Zielsetzung wird in US 2015/0184314 A1 vorgeschlagen, die Breite des Randbereichs der Halbleiterscheibe zu beschränken.

Die genannten Vorschläge erfordern eine Modifikation des verwendeten Suszeptors oder der Form des Randbereichs der Halbleiterscheibe.

Aufgabe der vorliegenden Erfindung ist es, die Ebenheit von Halbleiterscheiben mit abgeschiedener epitaktischer Schicht im Randbereich zu verbessern, ohne dafür den Suszeptor oder die Form des Randbereichs der Halbleiterscheibe verändern zu müssen.

Gelöst wird die Aufgabe durch ein Verfahren zum Abscheiden einer epitaktischen Schicht auf einer Vorderseite einer Halbleiterscheibe aus einkristallinem Material, umfassend
das Bereitstellen der Halbleiterscheibe;
das Anordnen der Halbleiterscheibe auf einem Suszeptor;
das Erhitzen der Halbleiterscheibe auf eine Abscheidetemperatur mittels Wärmestrahlung, die zu einer Vorderseite und zu einer Rückseite der Halbleiterscheibe gerichtet ist;
das Leiten eines Abscheidegases über die Vorderseite der Halbleiterscheibe; und das selektive Reduzieren der Intensität eines Anteils der Wärmestrahlung, die zur Rückseite der Halbleiterscheibe gerichtet ist, wodurch erste Teilbereiche am Rand der Halbleiterscheibe, in denen eine Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen, schwächer erhitzt werden, indem unter dem Suszeptor ein Ring, der von Suszeptor-Tragarmen gehalten wird, angeordnet wird, wobei der Ring nach innen weisende Vorsprünge aufweist, die jeweils einen Steg und ein Ringsegment umfassen und das Ringsegment aus einem Material mit niedrigem Transmissionsgrad im IR-Bereich des Spektrums besteht und eine Breite in Umfangsrichtung aufweist, die, ausgedrückt als Öffnungswinkel α, nicht weniger als 15° und nicht mehr als 25° beträgt.

Gegenstand der Erfindung ist des Weiteren eine Vorrichtung zum Abscheiden einer epitaktischen Schicht auf einer Vorderseite einer Halbleiterscheibe aus einkristallinem Material, umfassend
einen Suszeptor;
eine Einrichtung zum Halten und Drehen des Suszeptors mit einer Suszeptor-Tragwelle und Suszeptor-Tragarmen; und
einen Ring, der von den Suszeptor-Tragarmen gehalten wird und nach innen weisende Vorsprünge aufweist, die die Intensität von durch sie durchtretender Wärmestrahlung selektiv reduzieren, wodurch erste Teilbereiche am Rand einer auf dem Suszeptor abgelegten Halbleiterscheibe, in denen eine Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen, schwächer erhitzt werden, wobei die Vorsprünge jeweils einen Steg und ein Ringsegment umfassen und das Ringsegment aus einem Material mit niedrigem Transmissionsgrad im IR-Bereich des Spektrums besteht und eine Breite in Umfangsrichtung aufweist, die, ausgedrückt als Öffnungswinkel α, nicht weniger als 15° und nicht mehr als 25° beträgt.

Die Halbleiterscheibe oder zumindest ein die Oberfläche der Halbleiterscheibe umfassender Teil davon ist einkristallin und besteht vorzugsweise aus Silizium, Germanium oder aus einer Mischung dieser Elemente. Die Halbleiterscheibe kann vollständig aus einem der genannten Materialien bestehen. Es kann aber auch eine SOI-Scheibe (silicon on insulator), eine gebondete Halbleiterscheibe oder eine Substratscheibe sein, die bereits mit einer oder mehreren epitaktischen Schichten beschichtet worden ist. Die epitaktische Schicht besteht vorzugsweise aus Silizium, Germanium oder aus einer Mischung dieser Elemente, und enthält gegebenenfalls elektrisch aktiven Dotierstoff.

Die Halbleiterscheibe kann von einem Einkristall abgetrennt werden, der nach der FZ-Methode (float zone) oder nach der CZ-Methode kristallisiert wurde. Die CZ-Methode umfasst das Eintauchen eines Keimkristalls in eine Schmelze, die in einem Tiegel enthalten ist, und das Anheben des Keimkristalls und des daran kristallisierenden Einkristalls von der Schmelze.

Die Halbleiterscheibe hat einen Durchmesser von mindestens 200 mm, vorzugsweise mindestens 300 mm. Die Vorderseite der Halbleiterscheibe ist vorzugsweise <100>-orientiert oder <110>-orientiert.

Im Fall der <100>-Orientierung der Vorderseite kann der Randbereich der Vorderseite der Halbleiterscheibe in jeweils vier, sich abwechselnde erste und zweite Teilbereiche gegliedert werden. In den vier ersten Teilbereichen ist die Wachstumsgeschwindigkeit einer epitaktischen Schicht größer, als in den vier zweiten Teilbereichen des Randbereichs. Die Mitten der ersten Teilbereiche haben jeweils eine Winkelposition θ bezüglich des Umfangs der Halbleiterscheibe. Kennzeichnet eine Orientierungskerbe (notch) eine <110>-Richtung senkrecht zur <100>-Orientierung der Vorderseite der Halbleiterscheibe und wird dieser Richtung die Winkelposition θ von 270° zugeordnet, haben die Mitten der vier ersten Teilbereiche eine Winkelposition θ von 0°, 90°, 180° beziehungsweise 270°, entsprechend den Winkelpositionen der <110>-Richtungen senkrecht zur <100>-Orientierung der Vorderseite der Halbleiterscheibe.

Im Fall der <110>-Orientierung der Vorderseite kann der Randbereich der Vorderseite der Halbleiterscheibe in jeweils zwei, sich abwechselnde Teilbereiche gegliedert werden. In den zwei ersten Teilbereichen ist die Wachstumsgeschwindigkeit einer epitaktischen Schicht auf der Vorderseite der Halbleiterscheibe größer, als in den zwei zweiten Teilbereichen des Randbereichs. Kennzeichnet die Orientierungskerbe eine <110>-Richtung senkrecht zur <110>-Orientierung der Vorderseite der Halbleiterscheibe und wird dieser Richtung die Winkelposition θ von 270° zugeordnet, haben die Mitten der zwei ersten Teilbereiche eine Winkelposition θ von 90° beziehungsweise 270°, entsprechend den Winkelpositionen der <110>-Richtungen senkrecht zur <110>-Orientierung der Vorderseite der Halbleiterscheibe.

Während des Abscheidens einer epitaktischen Schicht auf der Vorderseite der Halbleiterscheibe liegt die Halbleiterscheibe auf dem Sims eines Suszeptors. Der Suszeptor kann einteilig ausgebildet sein oder besteht vorzugsweise aus einem Suszeptorring und einem Suszeptorboden. Die Halbleiterscheibe wird orientiert auf dem Suszeptor abgelegt, das heißt, ihre Orientierungskerbe hat eine definierte Lage auf dem Sims des Suszeptors. Die Halbleiterscheibe liegt so auf dem Suszeptor, dass die ersten Teilbereiche am Rand der Halbleiterscheibe weniger intensiv erhitzt werden, als die zweiten Teilbereiche. Die Wachstumsgeschwindigkeit der epitaktischen Schicht ist umso größer, je höher die Temperatur ist, und damit in den ersten Teilbereichen geringer, als in den zweiten Teilbereichen. Sie hängt jedoch nicht nur von der Temperatur ab, sondern auch von der Orientierung des Kristallgitters. Und weil in den ersten Teilbereichen wegen der Orientierung des Kristallgitters die Wachstumsgeschwindigkeit der epitaktischen Schicht größer ist, als in den zweiten Teilbereichen, wird insgesamt eine Angleichung der Wachstumsgeschwindigkeit der epitaktischen Schicht in den ersten und zweiten Teilbereichen erreicht. Mit anderen Worten, die Dicke der auf der Vorderseite der Halbleiterscheibe abgeschiedenen epitaktischen Schicht wird im Randbereich der Halbleiterscheibe gleichmäßiger, was sich in Kennzahlen wie dem ESFQR, der die Ebenheit einer beschichteten oder unbeschichteten Halbleiterscheibe im Randbereich beschreibt, bemerkbar macht.

Erfindungsgemäß werden die ersten Teilbereiche weniger intensiv erhitzt, weil die Intensität eines Anteils von Wärmestrahlung, der zur Rückseite der Halbleiterscheibe gerichtet ist, selektiv reduziert wird, und zwar ein Anteil der Wärmestrahlung, der maßgeblich zum Erhitzen der ersten Teilbereiche der Halbleiterscheibe beiträgt. Zu diesem Zweck befinden sich nach innen weisende Vorsprünge eines Rings im Strahlengang der Wärmestrahlung. Die Vorsprünge bestehen vollständig oder teilweise aus einem Material mit niedrigem Transmissionsgrad im IR-Bereich des Spektrums, vorzugsweise aus opakem Quarzglas. Der Transmissionsgrad, bezogen auf 10 mm Materialdicke, beträgt in diesem Bereich vorzugsweise nicht mehr als 20 %, besonders bevorzugt nicht mehr als 5 %. Die Dicke der Vorsprünge beträgt vorzugsweise nicht weniger als 5 mm und nicht mehr als 10 mm. Die Vorsprünge haben jeweils eine Breite in Umfangsrichtung von nicht weniger als 15° und nicht mehr als 25°, vorzugsweise 20°. Sie erstrecken sich radial nach innen, vom Innenumfang des Rings über eine Länge von vorzugsweise nicht weniger als 20 mm und nicht mehr als 30 mm. Ein Teil des erwähnten Anteils der Wärmestrahlung wird am Durchtritt durch die Vorsprünge gehindert. Dieser Effekt der Abschattung reicht aus, damit die Halbleiterscheibe in den ersten Teilbereichen in gewünschter Weise weniger intensiv erhitzt wird. Geeignetes Material aus opakem Quarzglas wird beispielsweise unter dem Handelsnamen OM^{®} 100 von Heraeus angeboten.

Der Ring mit den nach innen weisenden Vorsprüngen ist vorzugsweise derart ausgebildet, dass er in einen marktüblichen CVD-Reaktor zum Beschichten einzelner Halbleiterscheiben eingesetzt werden kann, ohne dass dieser zuvor baulich verändert werden muss. In einer erfindungsgemäßen Vorrichtung wird der Ring von den Suszeptor-Tragarmen des CVD-Reaktors gehalten und weist zu diesem Zweck Bohrungen auf, durch die Suszeptor-Stützstifte gesteckt werden können. Der Unterschied zwischen einer erfindungsgemäßen Vorrichtung und einem CVD-Reaktor in bekannter Ausführungsform besteht also darin, dass zusätzlich der beschriebene Ring unter dem Suszeptor angeordnet ist, und zwar so, dass die Vorsprünge des Rings und die ersten Teilbereiche am Rand einer auf dem Suszeptor abgelegten Halbleiterscheibe eine relative Lage zueinander einnehmen, die das Auftreten des beschriebenen Effekts der Abschattung ermöglicht. Nach dem Durchstecken der Suszeptor-Stützstifte ist die Lage der Vorsprünge festgelegt, und auch die Lage, die die ersten Kristallbereiche einnehmen müssen, denn diese ergibt sich dann entsprechend den Regeln der geometrischen Optik. Die Halbleiterscheibe wird in diesem Sinn in definierter Weise auf dem Suszeptor abgelegt.

Die Erfindung wird nachfolgend unter Bezugnahme auf Zeichnungen weiter erläutert.

### Kurzbeschreibung der Figuren

**Fig. 1** ist eine, den Stand der Technik repräsentierende Abbildung, die die relative Anordnung eines Suszeptorbodens, eines Suszeptorrings und einer Halbleiterscheibe zeigt.
**Fig.2** zeigt in Draufsicht eine Halbleiterscheibe mit <100>-Orientierung und **Fig.3** eine Halbleiterscheibe mit <110>-Orientierung.
**Fig.4** zeigt eine erfindungsgemäße Vorrichtung in Schnittdarstellung.
**Fig.5** **und** **Fig.6** zeigen in Draufsicht jeweils einen Ring, der Merkmal einer Vorrichtung ist, die nicht unter die Patentansprüche fällt.
**Fig.7** zeigt in Draufsicht einen Ring, der Merkmal einer erfindungsgemäßen Vorrichtung ist.
**Fig.8** und **Fig.9** zeigen jeweils den Unterschied Diff der Dicke einer epitaktisch beschichteten Halbleiterscheibe im Abstand von 1 mm vom Rand der Halbleiterscheibe zu einer mittleren Dicke der beschichteten Halbleiterscheibe in Abhängigkeit einer Umfangsposition CP, wobei die epitaktische Schicht entweder auf herkömmliche Weise abgeschieden wurde (Fig.8) oder in der Weise des Ausführungsbeispiels (Fig.9).

### Liste der verwendeten Bezugszeichen

- **1**: Suszeptor
- **2**: Suszeptorring
- **3**: Suszeptorboden
- **4**: Sims
- **5**: Halbleiterscheibe
- **6**: Orientierungskerbe
- **7**: Suszeptor-Tragwelle
- **8**: Suszeptor-Tragarm
- **9**: Ring
- **10**: Suszeptor-Stützstift
- **11**: Bohrung
- **12**: Scheiben-Hebewelle
- **13**: Scheiben-Hebestift
- **14**: Vorsprung
- **15**: Steg
- **16**: Ringsegment
- **17**: innerer Rand des Vorsprungs

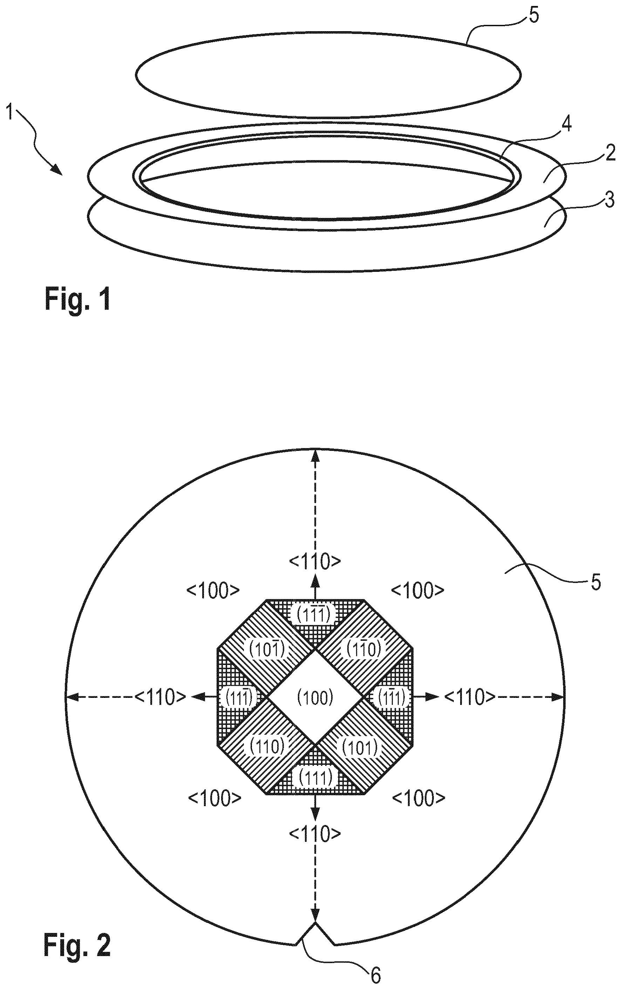

Die Anordnung gemäß Fig.1 umfasst einen Suszeptorboden 3 und einen Suszeptorring 2 mit einem Sims 4. Auf dem Sims 4 kann eine Halbleiterscheibe 5 im Randbereich der Rückseite der Halbleiterscheibe abgelegt werden. Der Suszeptorboden 3 und der Suszeptorring 2 bilden einen zweiteiligen Suszeptor 1. In Bezug auf die vorliegende Erfindung ist das unerheblich. Selbstverständlich kann auch ein einteiliger Suszeptor erfindungsgemäß eingesetzt werden.

Der Suszeptorboden 3 besteht vorzugsweise aus Graphit-Filz oder aus Graphit-Filz, der mit Siliziumcarbid beschichtet ist, oder aus Graphit, der mit Siliziumcarbid beschichtet ist, oder aus Siliziumcarbid, der Suszeptorring 2 vorzugsweise aus Siliziumcarbid oder aus einem anderen Material, das mit Siliziumcarbid beschichtet ist. Bei dem anderen Material handelt es sich vorzugsweise um Graphit oder Silizium. Der Suszeptorring 2 hat einen Innendurchmesser und einen Außendurchmesser. Der Innendurchmesser ist kleiner und der Außendurchmesser ist größer, als der Durchmesser der Halbleiterscheibe 5. Der Sims 4 des Suszeptorrings 2 erstreckt sich vom inneren Rand des Suszeptorrings 2 bis zu einer Stufe, die die Höhe des Suszeptorrings 2 vergrößert. Der Sims 4 ist vorzugsweise von der Stufe nach innen abfallend geformt.

Fig.2 zeigt eine Halbleiterscheibe 5 mit einer Orientierungskerbe 6. Die Halbleiterscheibe 5 weist eine <100>-Orientierung auf. Die Orientierungskerbe 6 markiert eine von vier <110>-Kristallrichtungen, die um den Umfang der Halbleiterscheibe im Abstand von 90° verteilt auf Ebenen im Bereich der Kante der Halbleiterscheibe hinweisen, auf denen eine epitaktische Schicht mit vergleichsweise hoher Geschwindigkeit wächst. Die gestrichelten Pfeile zeigen also auf die Mitten der ersten Teilbereiche, in denen die Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen. Mit einer Winkelposition der Orientierungskerbe bei 270° haben die Mitten der ersten Teilbereiche die Winkelpositionen 0°, 90°, 180° und 270°.

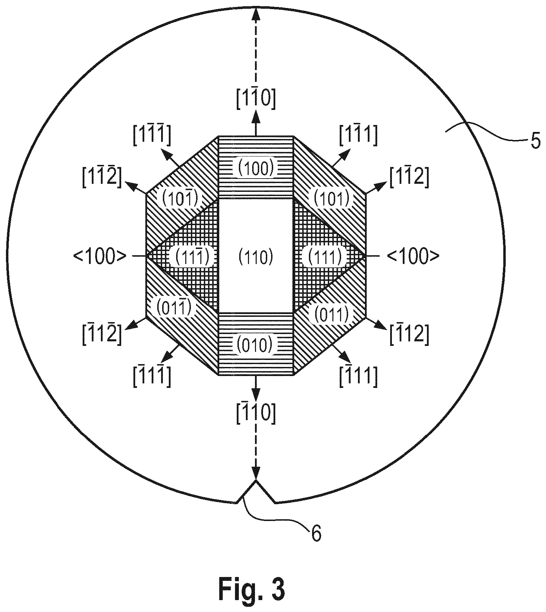

Fig. 3 zeigt Orientierungsmerkmale einer Halbleiterscheibe 5 mit <110>-Orientierung. Die Orientierungskerbe 6 markiert eine von zwei <110>-Kristallrichtungen, die um den Umfang der Halbleiterscheibe im Abstand von 180° verteilt auf Ebenen im Bereich der Kante der Halbleiterscheibe hinweisen, auf denen eine epitaktische Schicht mit vergleichsweise hoher Geschwindigkeit wächst. Die gestrichelten Pfeile zeigen also auf die Mitten der ersten Teilbereiche, in denen die Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen. Mit einer Winkelposition der Orientierungskerbe bei 270° haben die Mitten der ersten Teilbereiche die Winkelpositionen 90° und 270°.

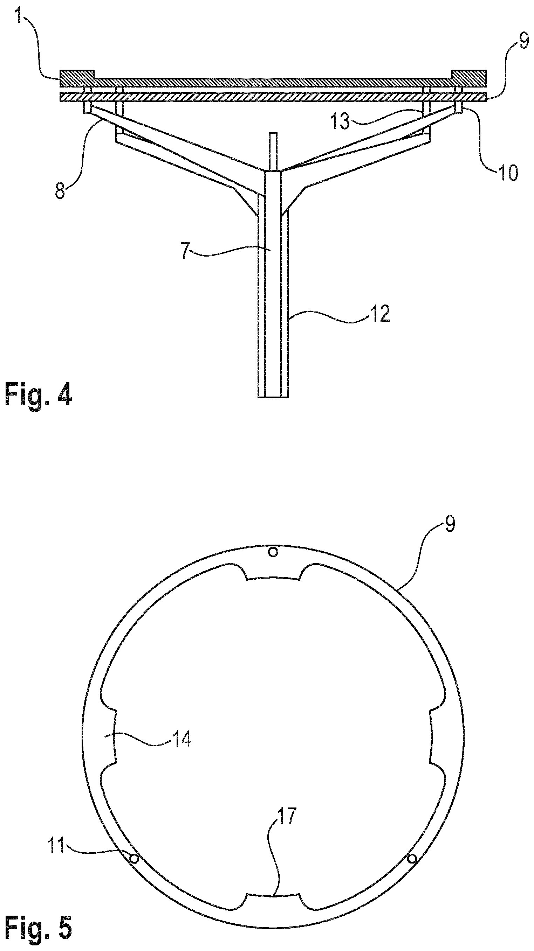

Eine erfindungsgemäße Vorrichtung (Fig.4) umfasst neben einem Suszeptor 1 eine Einrichtung zum Halten und Drehen des Suszeptors 1 mit einer Suszeptor-Tragwelle 7 und Suszeptor-Tragarmen 8. Des Weiteren kann die Einrichtung zum Halten und Drehen des Suszeptors 1 eine Scheiben-Hebewelle 12 umfassen sowie Scheiben-Hebestifte 13. Wesentliches Merkmal der Vorrichtung ist ein Ring 9, der von den Suszeptor-Tragarmen 8 gehalten wird und unter dem Suszeptor 1 angeordnet ist, ohne direkten Kontakt mit dem Suszeptor 1 zu haben. Der Ring 9 wird von den Suszeptor-Tragarmen 8 derart gehalten, dass er entlang seiner Umfangsrichtung nicht verschoben werden kann. Vorzugsweise befinden sich auf den Suszeptor-Tragarmen 8 Suszeptor-Stützstifte 10, die durch Bohrungen 11 des Rings 9 gesteckt sind. Der Abstand zwischen einer oberen Fläche des Rings 9 und einer unteren Fläche des Suszeptors 1 beträgt vorzugsweise nicht weniger als 5 mm und nicht mehr als 10 mm. Vorzugsweise befindet sich ein innerer Rand 17 des Vorsprungs 14 des Rings 9 (Fig.5, Fig.6 und Fig.7) an einer radialen Position, deren Abstand zu einem Zentrum Z des Rings 9 nicht weniger als 140 mm, vorzugsweise nicht weniger als 145 mm, besonders bevorzugt 148 mm bis 150 mm beträgt.

Fig.5 zeigt in Draufsicht einen Ring 9, der in der gezeigten Ausführungsform Bohrungen 11 und vier, nach innen weisende Vorsprünge 14 aufweist, die im Abstand von 90° über den Umfang verteilt angeordnet sind. Diese Ausführungsform, die nicht unter die Patentansprüche fällt, eignet sich zur Verwendung in einer Vorrichtung gemäß Fig.4, um darin eine epitaktische Schicht auf der Vorderseite einer Halbleiterscheibe abzuscheiden, die eine <100>-Orientierung hat. Der Ring 9 besteht vorzugsweise aus Quarzglas und die Vorsprünge 14 aus einem Material mit niedrigem Transmissionsgrad im IR-Bereich des Spektrums. Der Transmissionsgrad der Vorsprünge 14 beträgt in diesem Bereich, bezogen auf eine Materialdicke von 10 mm, vorzugsweise nicht mehr als 20 %, besonders bevorzugt nicht mehr als 5 %. Die Vorsprünge 14 bestehen vorzugsweise aus opakem Quarzglas.

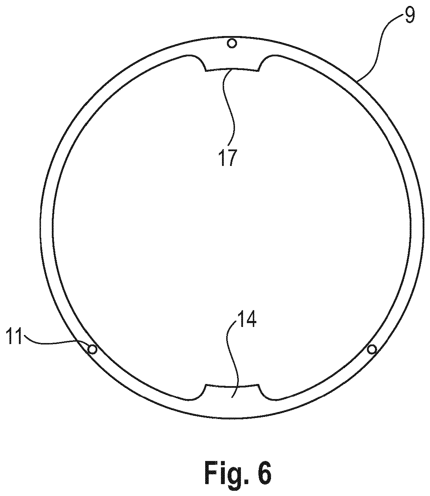

Fig.6 zeigt in Draufsicht einen Ring 9, der in der gezeigten Ausführungsform Bohrungen 11 und zwei, nach innen weisende Vorsprünge 14 aufweist, die im Abstand von 180° über den Umfang verteilt angeordnet sind. Diese Ausführungsform, die nicht unter die Patentansprüche fällt, eignet sich zur Verwendung in einer Vorrichtung gemäß Fig.4, um darin eine epitaktische Schicht auf der Vorderseite einer Halbleiterscheibe abzuscheiden, die eine <110>-Orientierung hat. Der Ring 9 besteht vorzugsweise aus Quarzglas und die Vorsprünge 14 aus einem Material mit niedrigem Transmissionsgrad im IR-Bereich des Spektrums. Der Trans-missionsgrad der Vorsprünge 14 beträgt in diesem Bereich, bezogen auf eine Materialdicke von 10 mm, vorzugsweise nicht mehr als 20 %, besonders bevorzugt nicht mehr als 5 %. Die Vorsprünge 14 bestehen vorzugsweise aus opakem Quarzglas.

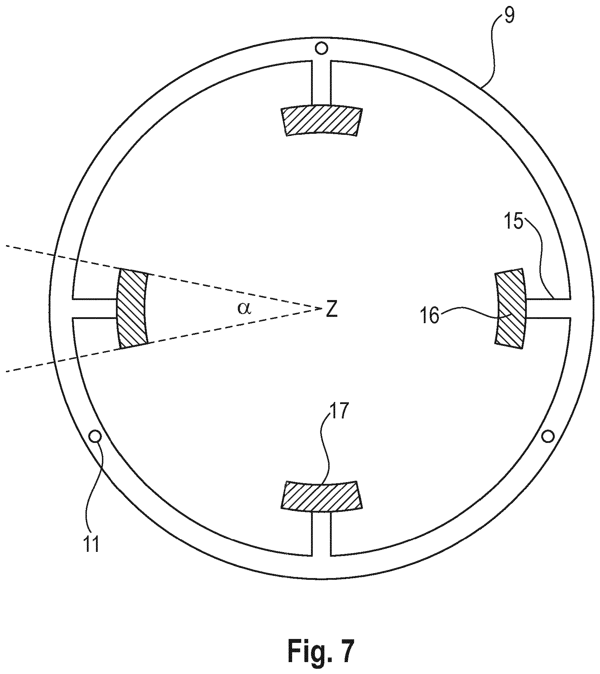

Fig.7 zeigt in Draufsicht einen Ring 9, der in der gezeigten Ausführungsform Bohrungen 11 und vier, nach innen weisende Vorsprünge 14 aufweist, die im Abstand von 90° über den Umfang verteilt angeordnet sind. Diese Ausführungsform eignet sich zur Verwendung in einer Vorrichtung gemäß Fig.4, um darin eine epitaktische Schicht auf der Vorderseite einer Halbleiterscheibe erfindungsgemäß abzuscheiden, die eine <100>-Orientierung hat. Die Vorsprünge 14 sind in der dargestellten Ausführungsform T-förmig und umfassen jeweils einen Steg 15 mit einer radialen Länge von vorzugsweise nicht weniger als 8 mm und nicht mehr als 18 mm und ein Ringsegment 16. Das Ringsegment 16 hat eine radiale Länge und eine Breite in Umfangsrichtung. Die radiale Länge des Ringsegments 16 beträgt vorzugsweise nicht weniger als 1,5 mm und nicht mehr als 8 mm, besonders bevorzugt nicht weniger als 3 mm und nicht mehr als 8 mm. Die Breite beträgt, ausgedrückt als Öffnungswinkel α nicht weniger als 15° und nicht mehr als 25°, besonders bevorzugt 20°. Der Ring 9 und die Stege 15 bestehen vorzugsweise aus Quarzglas und die Ringsegmente aus einem Material mit niedrigem Transmissionsgrad im IR-Bereich des Spektrums. Der Transmissionsgrad der Ringsegmente 16 beträgt in diesem Bereich, bezogen auf eine Materialdicke von 10 mm, vorzugsweise nicht mehr als 20 %, besonders bevorzugt nicht mehr als 5 %. Die Ringsegmente 16 bestehen vorzugsweise aus opakem Quarzglas.

### Beschreibung eines Ausführungsbeispiels

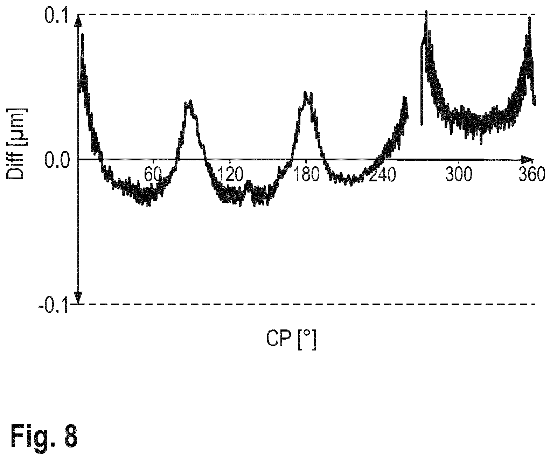

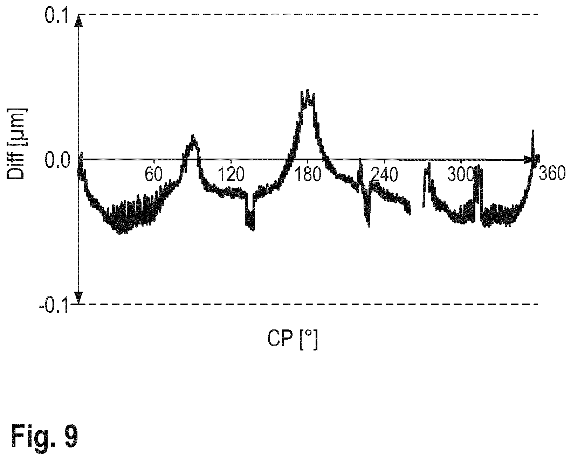

Halbleiterscheiben aus einkristallinem Silizium mit einem Durchmesser von 300 mm und einer <100>-Orientierung der Vorderseite wurden in einem Einzelscheiben-Reaktor mit einer epitaktischen Schicht aus Silizium beschichtet. Ein Teil der Halbleiterscheiben wurde auf einem Suszeptor gemäß Fig.1 liegend in einer Vorrichtung gemäß Fig.4 beschichtet, jedoch ohne dass der Ring 9 bereitgestellt worden war. Ein anderer Teil der Halbleiterscheiben wurde in gleicher Weise beschichtet, jedoch in Gegenwart eines Rings 9 in der nicht unter die Patentansprüche fallenden Ausführungsform gemäß Fig.5, der entsprechend Fig.4 angeordnet war. Die relative Lage der Halbleiterscheibe und des Rings war derart gewählt worden, dass die Intensität von Wärmestrahlung beim Durchtritt durch die Vorsprünge des Rings geschwächt wurde, und damit die Wachstumsgeschwindigkeit der epitaktischen Schicht in den ersten Teilbereichen der Halbleiterscheibe gezielt herabgesetzt wurde. Im Anschluss wurde jeweils der Unterschied zwischen der Dicke der beschichteten Halbleiterscheibe im Abstand von 1 mm vom Rand und einer mittleren Dicke der entsprechenden Halbleiterscheibe festgestellt. Dieser Unterschied ist bei einer in Gegenwart des Rings hergestellten Halbleiterscheibe deutlich geringer (Fig.9), als bei einer ohne den Ring hergestellten Halbleiterscheibe (Fig.8).

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zum Abscheiden einer epitaktischen Schicht auf einer Vorderseite einer Halbleiterscheibe aus einkristallinem Material, umfassend
das Bereitstellen der Halbleiterscheibe;
das Anordnen der Halbleiterscheibe auf einem Suszeptor;
das Erhitzen der Halbleiterscheibe auf eine Abscheidetemperatur mittels Wärmestrahlung, die zu einer Vorderseite und zu einer Rückseite der Halbleiterscheibe gerichtet ist;
das Leiten eines Abscheidegases über die Vorderseite der Halbleiterscheibe; und das selektive Reduzieren der Intensität eines Anteils der Wärmestrahlung, die zur Rückseite der Halbleiterscheibe gerichtet ist, **dadurch gekennzeichnet, dass** dadurch erste Teilbereiche am Rand der Halbleiterscheibe, in denen eine Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen, schwächer erhitzt werden, indem unter dem Suszeptor ein Ring, der von Suszeptor-Tragarmen gehalten wird, angeordnet wird, wobei der Ring nach innen weisende Vorsprünge aufweist zum selektiven Reduzieren der Intensität eines Anteils der Wärmestrahlung, wobei die Vorsprünge jeweils einen Steg und ein Ringsegment umfassen und das Ringsegment aus einem Material mit niedrigem Transmissionsgrad im IR-Bereich des Spektrums besteht und eine Breite in Umfangsrichtung aufweist, die, ausgedrückt als Öffnungswinkel α, nicht weniger als 15° und nicht mehr als 25° beträgt.

2. Vorrichtung zum Abscheiden einer epitaktischen Schicht auf einer Vorderseite einer Halbleiterscheibe aus einkristallinem Material, umfassend
einen Suszeptor;
eine Einrichtung zum Halten und Drehen des Suszeptors mit einer Suszeptor-Tragwelle und Suszeptor-Tragarmen; und
einen Ring, der von den Suszeptor-Tragarmen gehalten wird und nach innen weisende Vorsprünge aufweist, die die Intensität von durch sie durchtretender Wärmestrahlung selektiv reduzieren, wodurch erste Teilbereiche am Rand einer auf dem Suszeptor abgelegten Halbleiterscheibe, in denen eine Wachstumsgeschwindigkeit der epitaktischen Schicht bei einheitlicher Temperatur der Halbleiterscheibe wegen der Orientierung des einkristallinen Materials größer ist, als in benachbarten zweiten Teilbereichen, schwächer erhitzt werden, wobei die Vorsprünge jeweils einen Steg und ein Ringsegment umfassen und das Ringsegment aus einem Material mit niedrigem Transmissionsgrad im IR-Bereich des Spektrums besteht und eine Breite in Umfangsrichtung aufweist, die, ausgedrückt als Öffnungswinkel α, nicht weniger als 15° und nicht mehr als 25° beträgt.

3. Vorrichtung nach Anspruch 2, **dadurch gekennzeichnet, dass** der Ring aus Quarzglas besteht.

4. Vorrichtung nach Anspruch 2 oder Anspruch 3, **gekennzeichnet durch** vier Vorsprünge mit einem Abstand zu einem benachbarten Vorsprung von 90°.

5. Vorrichtung nach Anspruch 2 oder Anspruch 3, **gekennzeichnet durch** zwei Vorsprünge mit einem Abstand zu einem benachbarten Vorsprung von 180°.

## Claims

1. Method for depositing an epitaxial layer on a front side of a semiconductor wafer composed of monocrystalline material, comprising
providing the semiconductor wafer;
arranging the semiconductor wafer on a susceptor;
heating the semiconductor wafer to a deposition temperature by means of thermal radiation directed to a front side and to a rear side of the semiconductor wafer; conducting a deposition gas over the front side of the semiconductor wafer; and
selectively reducing the intensity of a portion of the thermal radiation that is directed to the rear side of the semiconductor wafer, **characterized in that** as a result first partial regions at the edge of the semiconductor wafer, in which first partial regions a growth rate of the epitaxial layer is greater than in adjacent second partial regions given uniform temperature of the semiconductor wafer owing to the orientation of the monocrystalline material, are heated more weakly, by virtue of the fact that a ring held by susceptor carrying arms is arranged below the susceptor, wherein the ring has inwardly facing projections for selectively reducing the intensity of a portion of the thermal radiation, wherein the projections each comprise a web and a ring segment, and the ring segment consists of a material having a low transmittance in the IR range of the spectrum and has a width in a circumferential direction which, expressed as an aperture angle α, is not less than 15° and not more than 25°.

2. Apparatus for depositing an epitaxial layer on a front side of a semiconductor wafer composed of monocrystalline material, comprising
a susceptor;
a device for holding and rotating the susceptor having a susceptor carrying shaft and susceptor carrying arms; and a ring that is held by the susceptor carrying arms and has inwardly facing projections that selectively reduce the intensity of thermal radiation passing through them, as a result of which first partial regions at the edge of a semiconductor wafer placed on the susceptor, in which first partial regions a growth rate of the epitaxial layer is greater than in adjacent second partial regions given uniform temperature of the semiconductor wafer owing to the orientation of the monocrystalline material, are heated more weakly, wherein the projections each comprise a web and a ring segment, and the ring segment consists of a material having a low transmittance in the IR range of the spectrum and has a width in a circumferential direction which, expressed as an aperture angle α, is not less than 15° and not more than 25°.

3. Apparatus according to Claim 2, **characterized in that** the ring consists of quartz glass.

4. Apparatus according to Claim 2 or Claim 3, **characterized by** four projections having a distance to an adjacent projection of 90°.

5. Apparatus according to Claim 2 or Claim 3, **characterized by** two projections having a distance to an adjacent projection of 180°.

## Revendications

1. Procédé pour déposer une couche épitaxiale sur une face avant d'une tranche de semi-conducteur faite d'un matériau monocristallin, comprenant
la fourniture de la tranche de semi-conducteur ;
la mise en place de la tranche de semi-conducteur sur un suscepteur ;
le chauffage de la tranche de semi-conducteur à une température de dépôt au moyen d'un rayonnement thermique dirigé vers une face avant et vers une face arrière de la tranche de semi-conducteur ;
le passage d'un gaz de dépôt sur la face avant de la tranche de semi-conducteur ; et
la réduction sélective de l'intensité d'une partie du rayonnement thermique dirigé vers la face arrière de la tranche de semi-conducteur, **caractérisé en ce que** des premières zones partielles au bord de la tranche de semi-conducteur, dans lesquelles une vitesse de croissance de la couche épitaxiale à température uniforme de la tranche de semi-conducteur est plus élevée, en raison de l'orientation du matériau monocristallin, que dans les deuxièmes zones partielles adjacentes, sont moins chauffées par le fait qu'un anneau, maintenu par des bras de support du suscepteur, est disposé sous le suscepteur, l'anneau présentant des saillies tournées vers l'intérieur pour réduire sélectivement l'intensité d'une partie du rayonnement thermique, les saillies comprenant respectivement une âme et un segment annulaire, et le segment annulaire étant constitué d'un matériau présentant une faible transmittance dans la région IR du spectre et une largeur dans la direction circonférentielle qui, exprimée en angle d'ouverture α, n'est pas inférieure à 15° et n'est pas supérieure à 25°.

2. Dispositif pour déposer une couche épitaxiale sur une face avant d'une tranche de semi-conducteur faite d'un matériau monocristallin, comprenant un suscepteur ;
un dispositif pour maintenir et faire tourner le suscepteur avec un arbre de support de suscepteur et des bras de support de suscepteur ; et
un anneau qui est maintenu par les bras de support du suscepteur et qui présente des saillies dirigées vers l'intérieur qui réduisent sélectivement l'intensité du rayonnement thermique les traversant, de sorte que des premières zones partielles, au bord d'une tranche de semi-conducteur déposée sur le suscepteur, dans lesquelles une vitesse de croissance de la couche épitaxiale à température uniforme de la tranche de semi-conducteur est plus élevée, en raison de l'orientation du matériau monocristallin, que dans des deuxièmes zones partielles adjacentes, sont moins chauffées, les saillies comprenant respectivement une âme et un segment annulaire, et le segment annulaire étant constitué d'un matériau présentant une faible transmittance dans la région IR du spectre et une largeur dans la direction circonférentielle qui, exprimée en angle d'ouverture α, n'est pas inférieure à 15° et n'est pas supérieure à 25°.

3. Dispositif selon la revendication 2, **caractérisé en ce que** l'anneau est constitué de verre de quartz.

4. Dispositif selon la revendication 2 ou la revendication 3, **caractérisé par** quatre saillies présentant un espacement de 90° par rapport à une saillie voisine.

5. Dispositif selon la revendication 2 ou 3, **caractérisé par** deux saillies présentant un espacement de 180° par rapport à une saillie voisine.
